# EUROPÄISCHE PATENTSCHRIFT

(11) **EP 4 500 225 B1**
(45) Veröffentlichungstag und Bekanntmachung des Hinweises auf die Patenterteilung: **18.11.2026**
(21) Anmeldenummer: 23712472.2
(22) Anmeldetag: 15.03.2023
(51) Int. Cl.: G01S 7/526, G01S 7/537, G01S 15/931

(54) **ULTRASCHALLSENSOR MIT ZUSCHALTBAREM KERBFILTER**
ULTRASOUND SENSOR WITH SWITCHABLE NOTCH FILTER
CAPTEUR À ULTRASONS À FILTRE COUPE-BANDE COMMUTABLE

(30) Priorität: 25.03.2022 DE 102022107066
(43) Veröffentlichungstag der Anmeldung: 05.02.2025
(73) Patentinhaber: Valeo Schalter und Sensoren GmbH, 74321 Bietigheim-Bissingen (DE)
(72) Erfinder: MAURER, Philipp, 74321 Bietigheim-Bissingen (DE); WALGER, Martin, 74321 Bietigheim-Bissingen (DE)
(74) Vertreter: Pothmann, Karsten
(86) Internationale Anmeldenummer: PCT/EP2023/056551
(87) Internationale Veröffentlichungsnummer: WO 2023/180133

(56) Entgegenhaltungen:
- EP-B1- 1 617 752
- DE-A1- 102008 044 366
- DE-A1- 19 901 835

## Beschreibung

Die vorliegende Erfindung betrifft einen Ultraschallsensor zum Aussenden von Ultraschallsignalen und zum Empfangen von Ultraschallechos, insbesondere zur Verwendung an einem Fahrzeug, mit einer Ultraschallmembran, einem an der Ultraschallmembran angebrachten Piezoelement, einer Verstärkerschaltung, und einer Verbindungsbeschaltung, welche das Piezoelement und die Verstärkerschaltung elektrisch verbindet.

Des Weiteren betrifft die vorliegende Erfindung ein Ultraschallerfassungssystem mit einer Mehrzahl Ultraschallsensoren zur Erfassung einer Umgebung, insbesondere einer Umgebung eines Fahrzeugs, basierend auf von den Ultraschallsensoren bereitgestellten Sensorinformationen, mit einer Mehrzahl Ultraschallsensoren, die über eine Datenverbindung miteinander verbunden sind, wobei einer der Ultraschallsensoren als Master ausgeführt ist, um die Sensorinformation von wenigstens einem weiteren, als Slave ausgeführten Ultraschallsensor zu empfangen und zu verarbeiten, um die Umgebung des Fahrzeugs zu erfassen.

Auch betrifft die vorliegende Erfindung ein Fahrunterstützungssystem mit wenigstens einem Ultraschallsensor zur Bereitstellung von Sensorinformation, und einem Steuergerät, wobei der wenigstens eine Ultraschallsensor und das Steuergerät über eine Datenverbindung miteinander verbunden sind, und das Steuergerät ausgeführt ist, die Sensorinformation von dem wenigstens einen Ultraschallsensor zu empfangen und zu verarbeiten, um die Umgebung des Fahrzeugs zu erfassen.

Ultraschallsensoren senden Ultraschallpulse aus, die von Objekten in der Umgebung als Ultraschallechos reflektiert werden. Diese Ultraschallechos können von den Ultraschallsensoren empfangen werden, um aus einer Zeitdifferenz zwischen dem Aussenden von Ultraschallpulsen und dem Empfang von Ultraschallechos Abstände der Objekte zu den Ultraschallsensoren zu erfassen.

Derartige Ultraschallsensoren werden heutzutage zahlreich in Fahrunterstützungssystemen an Fahrzeugen eingesetzt, um verschiedene Funktionen zu übernehmen, beispielsweise um Parklücken zu erfassen, Parklücken zu vermessen, Abstände zu Hindernissen während eines Parkvorgangs zu überwachen, oder auch um einen toten Winkel des Fahrzeugs beim Fahren zu überwachen. Die Fahrunterstützungssysteme können als Fahrerassistenzsysteme ausgeführt sein, um einen menschlichen Fahrzeugführer beim Führen des Fahrzeugs zu unterstützen, oder auch um eine Unterstützungsfunktion für autonome Fahrfunktionen bereitzustellen.

Die Ultraschallsensoren umfassen eine Ultraschallmembran, an der ein Piezoelement angebracht ist, welches eine elektromechanische Energiewandlung durchführt und Ultraschallsignale in elektrische Signale wandelt. Diese elektrischen Signale werden über eine Verbindungsbeschaltung einem Verstärker zugeführt, der aus den elektrischen Signalen ein Empfangssignal bereitstellt, beispielsweise als Hüllkurve. In aktuellen Ultraschallsensoren erfolgt auch das Aussenden von Ultraschallpulsen über dieselbe Ultraschallmembran.

Die Ultraschallsensoren arbeiten typischerweise auf einem oder mehreren Kanälen in einem engen Frequenzband, welches im Bereich von etwa 50 kHz liegt. Bei mehreren Kanälen liegen die Kanäle typischerweise in einem Bereich von wenigen Kilohertz um etwa 50 kHz. Beispielsweise kann ein einkanaliger Ultraschallsensor bei einer Mittenfrequenz von etwa 51 kHz senden und empfangen, während bei einem mehrkanaligen Ultraschallsensor ein erster Kanal bei einer Mittenfrequenz von 51 kHz liegen kann, während ein zweiter Empfangskanal um 3 kHz verschoben ist, also beispielsweise bei 48 kHz oder 54 kHz liegt. Prinzipiell können auch zwei Kanäle mit Mittenfrequenzen von 48 kHz und 54 kHz verwendet werden. Auch ein Umschalten zwischen den Kanälen kann erfolgen.

Das Erfassen der Ultraschallechos erfolgt digital, d.h. ein Empfangssignal des Ultraschallsensors wird nach der Verstärkung abgetastet und quantisiert. Nach dem Abtasttheorem ist dafür eine Abtastfrequenz erforderlich, die wenigstens doppelt so hoch ist wie die Signalfrequenz, also minimal etwa 100 kHz. In der Praxis werden jedoch deutlich höhere Abtastfrequenzen verwendet, um die Ultraschallechos zu erfassen.

Beim Betrieb der Ultraschallsensoren können sich elektromagnetische Störungen ergeben beispielsweise durch das induktive Laden von Elektrofahrzeugen, die typischerweise bei einer Frequenz von etwa 150 kHz auftreten. Auch schlüssellose Zugangssysteme ("keyless entry") senden typischerweise Signale mit einer Frequenz von etwa 125 kHz aus, die mit in Türgriffen verbauten Ferritantennen abgestrahlt werden und zu entsprechenden Störungen führen können. Beide dieser beispielhaften Störungen liegen also oberhalb der minimalen Abtastfrequenz. Bei einer Abtastung mit hohen Abtastfrequenzen, beispielsweise im Bereich einer sechsfachen oder achtfachen Signalfrequenz, können solche Störungen erkannt und entsprechend verarbeitet werden. Dies ist jedoch mit hohen Kosten für die Abtastung verbunden. Bei einer geringengeren Abtastfrequenz, beispielsweise mit nur einer vierfachen Abtastfrequenz, können diese Störungen zu Aliassignalen führen, welches die empfangenen Ultraschallechos überlagern und somit eine korrekte Funktion der Ultraschallsensoren verhindern. Die Verwendung von Tiefpassfiltern hat sich als nicht praktikabel erwiesen, da diese Filter entweder sehr teuer sind oder auch eine Filterung von empfangenen Ultraschallechos erfolgt. Dadurch wird der nutzbare Empfangspegel herabgesetzt und eine maximale Reichweite der Ultraschallsensoren wird reduziert.

In diesem Zusammenhang ist aus der EP 1 617 752 B1 ein Verfahren zum Bestimmen der Resonanzfrequenz eines passiven Ultraschallsensors mit mindestens einem schwingfähigen Glied bekannt.

Aus der WO 2011/163475 A1 ist eine analoge Signalverarbeitung in einem Bildgebungssystem bekannt, z. B. einem medizinischen Ultraschall-Bildgebungssystem. Das System umfasst mehrere steuerbare Eingangsverarbeitungsblöcke, von denen jeder eine zeitdiskrete analoge Signalverarbeitungsstufe implementiert, wie z. B. Zeitbereichsfilterung für fraktionierte Zeitverzögerung, Anti-Alias-Filterung oder angepasste Filterung.

Aus der DE19901835A1 ist ein selbstabstimmendes Kristall-Kerbfilter bekannt, das für die Unterdrückung eines Trägersignals in einem Empfangskanal eines Ultraschall-Bildgebungssystems geeignet ist. Das Kristall-Kerbfilter gemäß der bevorzugten Ausführungsform weist eine Resonanzfrequenz auf, die elektronisch abgestimmt wird. Durch eine elektronische Abstimmung der Resonanzfrequenz kann ein präzisionsgesteuerter Kristall mit Kosten der zusätzlichen Abstimmschaltkreise umgesetzt werden. Die Schaltung enthält das selbstabstimmende Kristall-Kerbfilter einen Servorwiderstand, ein einfaches Kristall-Kerbfilter, eine Abstimmdiode, einen D/A-Umsetzer sowie einen Widerstand parallel zu dem Kristall geschaltet.

Aus der DE102008044366A1 ist eine Erfassungsvorrichtung zum Erfassen eines Umfeldes eines Fahrzeugs bekannt, die einen Ultraschallwandler und einen Sendepulsmodulator aufweist. Der Sendepulsmodulator erzeugt ein pulsmoduliertes Sendesignal mit einem Sendepulsabschnitt konstanter Trägerfrequenz und einem Chirp-Sendepulsabschnitt mit zeitlich zu- und/oder abnehmender Trägerfrequenz.

Ausgehend von dem oben genannten Stand der Technik liegt der Erfindung somit die Aufgabe zugrunde, einen Ultraschallsensor wie auch ein Fahrunterstützungssystem mit wenigstens einem Ultraschallsensor anzugeben, die eine geringe Anfälligkeit für Störungen aufweisen und einen hohen Empfangspegel für empfangene Ultraschallechos ermöglichen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Ultraschallsensor zum Aussenden von Ultraschallsignalen und zum Empfangen von Ultraschallechos angegeben, insbesondere zur Verwendung an einem Fahrzeug, mit einer Ultraschallmembran, einem an der Ultraschallmembran angebrachten Piezoelement, einer Verstärkerschaltung, und einer Verbindungsbeschaltung, welche das Piezoelement und die Verstärkerschaltung elektrisch verbindet, wobei die Verbindungsbeschaltung ein zuschaltbares Kerbfilter mit einer Filterfrequenz umfasst, und der Ultraschallsensor ausgeführt ist, das Kerbfilter bei einer Störung im Bereich der Filterfrequenz beim Empfang der Ultraschallechos zuzuschalten.

Erfindungsgemäß ist des Weiteren ein Ultraschallerfassungssystem mit einer Mehrzahl Ultraschallsensoren zur Erfassung einer Umgebung, insbesondere einer Umgebung eines Fahrzeugs, basierend auf von den Ultraschallsensoren bereitgestellten Sensorinformationen angegeben, mit einer Mehrzahl Ultraschallsensoren, die über eine Datenverbindung miteinander verbunden sind, wobei einer der Ultraschallsensoren als Master ausgeführt ist, um die Sensorinformation von wenigstens einem weiteren, als Slave ausgeführten Ultraschallsensor zu empfangen und zu verarbeiten, um die Umgebung des Fahrzeugs zu erfassen, wobei die Ultraschallsensoren wie oben angegeben ausgeführt sind.

Erfindungsgemäß ist außerdem ein Fahrunterstützungssystem angegeben mit wenigstens einem Ultraschallsensor zur Bereitstellung von Sensorinformation, und einem Steuergerät, wobei der wenigstens eine Ultraschallsensor und das Steuergerät über eine Datenverbindung miteinander verbunden sind, und das Steuergerät ausgeführt ist, die Sensorinformation von dem wenigstens einen Ultraschallsensor zu empfangen und zu verarbeiten, um die Umgebung des Fahrzeugs zu erfassen, wobei der wenigstens eine Ultraschallsensor wie oben angegeben ausgeführt ist.

Grundidee der vorliegenden Erfindung ist es also, den Ultraschallsensor mit einem zuschaltbaren Kerbfilter auszugestalten, so dass einerseits auftretende Störungen mit der Filterfrequenz gefiltert werden können und andererseits ohne zugeschaltetes Kerbfilter keine zusätzliche Dämpfung im System auftritt. Ein solcher Ultraschallsensor kann somit bei auftretenden Störungen das Kerbfilter zuschalten, so dass die Störungen gefiltert werden können, um einen kontinuierlichen Empfang von Ultraschallechos zu ermöglichen. Im Fall, dass keine Störungen auftreten, wird das Kerbfilter nicht zugeschaltet und ist somit deaktiviert, wodurch in diesem Normalbetrieb die empfangenen Ultraschallechos nicht zusätzlich durch das Kerbfilter gedämpft werden. Solche Kerbfilter (engl. Notch-Filter) weisen ein schmales Sperrband um die Filterfrequenz f_{F} auf, so dass der Frequenzgang einer tiefen Kerbe mit hoher Selektivität entspricht, wodurch das Kerbfilter sehr gut geeignet ist, um schmalbandige Störungen zu filtern und Nutzsignale nur gering zu dämpfen. Damit ist das Kerbfilter besonders gut für das Filtern bekannter Störer mit einer bestimmten Störfrequenz geeignet. Somit können also Störungen, die bei einer bekannten Störfrequenz auftreten, beispielsweise durch das induktive Laden von Elektrofahrzeugen, typischerweise mit einer Störfrequenz von etwa 150 kHz, oder auch durch schlüssellose Zugangssysteme ("keyless entry"), typischerweise mit einer Störfrequenz von etwa 125 kHz von in Türgriffen verbauten Ferritantennen, zuverlässig gefiltert werden. Allerdings lässt sich auch bei sehr frequenzselektiven Kerbfiltern nur mit großem Aufwand vermeiden, dass Dämpfungen auftreten, die sich in den Ultraschallfrequenzbereich der Ultraschallsensoren erstrecken. Es kann also auch eine Dämpfung des Nutzsignals auftreten. Hierbei kann es sich um Dämpfungen des Nutzsignals von wenigen dB handeln, die jedoch im Normalbetrieb die Reichweite des Ultraschallsensors reduzieren können. Durch das Zuschalten des Kerbfilters bei Bedarf, also bei auftretenden Störungen, kann das Problem der Dämpfung des Nutzsignals im Normalbetrieb vermieden werden. Nur im zugeschalteten Zustand hat das Kerbfilter einen Einfluss auf die Verbindungsbeschaltung.

Insgesamt ermöglichen die erfindungsgemäßen Ultraschallsensoren auch einen zuverlässigen Betrieb beispielsweise in der Nähe von geparkten Fahrzeugen, wo Störungen durch das induktive Laden von Elektrofahrzeugen, typischerweise bei einer Frequenz von etwa 150 kHz, oder auch durch schlüssellose Zugangssysteme ("keyless entry"), typischerweise bei einer Frequenz von etwa 125 kHz mit in Türgriffen verbauten Ferritantennen, auftreten können. Insbesondere im Bereich von Parkplätzen, Parkhäusern oder Parkgaragen kann das Zuschalten des Kerbfilters daher vorteilhaft sein.

Dabei kann das Kerbfilter einfach und kostengünstig realisiert werden. Das Kerbfilter umfasst üblicherweise passive Komponenten, was für ein einfaches Filter besonders vorteilhaft ist. Dies gilt insbesondere für die Verwendung in Ultraschallsensoren, die wenig Bauraum bereitstellen für aufwendig gestaltete Filter.

Der Ultraschallsensor kann einen an sich üblichen Aufbau aufweisen. Ultraschallsensoren sind als solche prinzipiell bekannt, so dass darauf nicht im Detail eingegangen werden muss.

Der Ultraschallsensor umfasst eine Ultraschallmembran zum Aussenden von Ultraschallpulsen und zum Empfangen von Ultraschallechos. Es wird also dieselbe Membran zum Senden von Ultraschallpulsen wie auch zum Empfang von Ultraschallechos verwendet.

An der Ultraschallmembran ist das Piezoelement angebracht. Bei aktuellen Ultraschallsensoren ist das Piezoelement meist innenseitig an die Ultraschallmembran geklebt. Das Piezoelement führt eine elektromechanische Energiewandlung durch und wandelt die empfangenen Ultraschallechos in elektrische Signale. Die Verbindungsbeschaltung umfasst typischerweise einen Koppelkondensator und einen HF-Tiefpass, um hochfrequente Störungen zu filtern und zur Strombegrenzung. Die elektrischen Signale werden über die Verbindungsbeschaltung der Verstärkerschaltung zugeführt. Die Verstärkerschaltung kann die elektrischen Signale verstärken und ein Empfangssignal bereitstellen, beispielsweise als Hüllkurve. Die Strombegrenzung durch den Koppelkondensator wirkt auch beim Senden der Ultraschallpulse.

Verbreitet sind heutzutage Ultraschallerfassungssysteme mit einer Mehrzahl von Ultraschallsensoren, die an einer Vorderseite und/oder einer Rückseite des Fahrzeugs angebracht sind. ein solches System kann beispielsweise unabhängig eine Überwachung der Vorder- bzw. Rückseite des Fahrzeugs durchführen.

Die Ultraschallsensoren als Master und Slave(s) können prinzipiell identische Ultraschallsensoren sein, die sich lediglich durch ihre Konfiguration unterscheiden. Entsprechend kann jeder der Ultraschallsensoren als Master oder Slave verwendet werden. Die als Slaves ausgeführten Ultraschallsensoren können über individuelle Datenverbindungen mit dem als Master ausgeführten Ultraschallsensor verbunden sein, oder die als Slaves ausgeführten Ultraschallsensoren können über eine als Datenbus ausgeführte Datenverbindung mit dem als Master ausgeführten Ultraschallsensor verbunden sein. Bevorzugt ist eine kaskadierte Anordnung der Ultraschallsensoren. Der als Master ausgeführte Ultraschallsensor wiederum kann über eine weitere Datenverbindung mit einer übergeordneten Steuereinheit des Fahrzeugs verbunden sein.

Der als Master ausgeführte Ultraschallsensor empfängt die Sensorinformationen von dem wenigstens einen als Slave ausgeführten Ultraschallsensor. Der als Master ausgeführte Ultraschallsensor kann dabei als Sensorinformationen beispielsweise Hüllkurven der empfangenen Ultraschallechos von den als Slaves ausgeführten Ultraschallsensoren empfangen, oder lediglich Informationen über relevante, empfangene Ultraschallechos. Diese Sensorinformationen werden von dem als Master ausgeführten Ultraschallsensor verarbeitet, um so die Erfassung der Umgebung des Fahrzeugs durchzuführen.

In dem Fahrunterstützungssystem können mehrere Ultraschallsensoren verwendet werden, um mit einem oder mehreren Ultraschallsensor(en) Ultraschallpulse auszusenden und deren Ultraschallechos mit einem oder mehreren Ultraschallsensor(en) zu empfangen. Das Aussenden von Ultraschallpulsen kann also für jeden Ultraschallsensor unabhängig vom Empfangen der Ultraschallechos durchgeführt werden. Verbreitet ist eine Ausgestaltung der Ultraschallsensoren, bei der die Ultraschallsensoren Ultraschallechos der von ihnen selbst ausgesendeten Ultraschallpulse empfangen. Die Ultraschallsensoren sind auch hier vorzugsweise identisch ausgeführt.

Das Fahrunterstützungssystem kann ein an sich beliebiges Fahrunterstützungssystem mit wenigstens einem Ultraschallsensor sein. Solche Fahrunterstützungssysteme können verschiedene Unterstützungsfunktionen übernehmen, beispielsweise Parklücken erfassen oder vermessen, Abstände zu Hindernissen während eines Parkvorgangs überwachen, oder auch einen toten Winkel des Fahrzeugs beim Fahren überwachen, um nur einige der aktuell am weitesten verbreiteten Funktionen zu nennen. Das Fahrunterstützungssystem kann als Fahrerassistenzsystem ausgeführt sein, um einen menschlichen Fahrzeugführer beim Führen des Fahrzeugs zu unterstützen, oder auch um eine Unterstützungsfunktion für autonome Fahrfunktionen bereitzustellen.

Verbreitet sind heutzutage Fahrunterstützungssysteme mit einer Mehrzahl von Ultraschallsensoren, die an einer Vorderseite und/oder einer Rückseite des Fahrzeugs angebracht sind. Zusätzlich finden Ultraschallsensoren an den Fahrzeuglängsseiten immer mehr Verbreitung.

Die Ultraschallsensoren können einzeln oder in Gruppen über eine Datenverbindung oder über mehrere mit dem Steuergerät verbunden sein. Prinzipiell ist es auch möglich, dass Gruppen von Ultraschallsensoren unabhängig von anderen Ultraschallsensoren mit einem Steuergerät verbunden sind. In dem Fall können also mehrere Fahrunterstützungssysteme mit jeweils einer Gruppe von Ultraschallsensoren an dem Fahrzeug installiert sein.

Das Steuergerät empfängt die Sensorinformationen von dem wenigstens einen Ultraschallsensor. Das Steuergerät kann dabei als Sensorinformationen beispielsweise Hüllkurven der empfangenen Ultraschallechos von den Ultraschallsensoren empfangen, oder lediglich Informationen über relevante, empfangene Ultraschallechos. Diese Sensorinformationen werden von dem Steuergerät verarbeitet, um so die Erfassung der Umgebung des Fahrzeugs durchzuführen.

In vorteilhafter Ausgestaltung der Erfindung ist das zuschaltbare Kerbfilter als Doppel-T-Filter ausgeführt. Solche Kerbfilter als Doppel-T-Filter weisen einen einfachen Aufbau auf. Doppel-T-Filter können mit wenigen unterschiedlichen Bauteilen realisiert werden. Somit können Doppel-T-Filter kostengünstig bereitgestellt werden, wobei sie gleichzeitig eine gute frequenzspezifische Dämpfung aufweisen. In einer Abwandlung kann basierend auf einer Stern-Dreieck-Umwandlung auch ein Doppel-Pi-Filter verwendet werden.

In vorteilhafter Ausgestaltung der Erfindung weist das zuschaltbare Kerbfilter einen Aufbau mit gleichartigen Widerständen und/oder mit gleichartigen Kondensatoren auf, wobei die gleichartigen Widerstände und/oder die gleichartigen Kondensatoren Teil eines entsprechenden Widerstandsnetzwerks und/oder eines entsprechenden Kondensatornetzwerks sind. Widerstandsnetzwerke sind auch als Widerstandsarrays bekannt und weisen eine Mehrzahl gleichartiger Einzelwiderstände auf, die einzeln beschaltet werden können. Entsprechendes gilt für Kondensatornetzwerke, die auch als Kondensatorarrays bekannt sind, und eine Mehrzahl gleichartiger Einzelkondensatoren aufweisen, die einzeln beschaltet werden können. Die Anzahl der Einzelwiderstände bzw. Einzelkondensatoren kann je nach Widerstandsnetzwerk bzw. Kondensatornetzwerk unterschiedlich sein. Durch diesen Aufbau kann das Filter sehr einfach und auch kompakt bereitgestellt werden. Verschiedene Widerstandswerte oder Kapazitäten können realisiert werden, indem Widerstände bzw. Kondensatoren des entsprechenden Widerstandsnetzwerks bzw. Kondensatornetzwerks in Reihe und/oder parallel verschaltet werden.

In vorteilhafter Ausgestaltung der Erfindung ist die Verstärkerschaltung mit einer anwendungsspezifischen integrierten Schaltung ausgeführt, und der Ultraschallsensor ist ausgeführt, das Kerbfilter bei einer Störung im Bereich der Filterfrequenz beim Empfang der Ultraschallechos mittels der anwendungsspezifischen integrierten Schaltung zuzuschalten. Solche anwendungsspezifischen integrierten Schaltungen sind auch als ASICs (engl. "application-specific integrated circuit") bekannt. Diese anwendungsspezifischen integrierten Schaltungen ermöglichen eine einfache Bereitstellung der Verstärkerschaltung mit gewünschten Eigenschaften. Die anwendungsspezifischen integrierten Schaltungen basieren typischerweise auf Standarddesigns, was es ermöglicht, zusätzliche Funktionen einfach bereitzustellen, ohne andere ASICs zu verwenden. Besonders bevorzugt umfasst die Verstärkerschaltung einen oder mehrere GPIOs (engl. general-purpose input/output), die in den anwendungsspezifischen integrierten Schaltungen entsprechend belegt werden können, um das Kerbfilter zuzuschalten. Beispielsweise kann über den oder die GPIO(s) und wenigstens einen in der anwendungsspezifischen integrierten Schaltung vorgesehen Schalter das Kerbfilter mit Masse verbunden werden, um das Kerbfilter zuzuschalten. Ohne diese Masseverbindung ist das Kerbfilter dann deaktiviert. Auch weitere Funktionen können unter Verwendung von GPIOs des ASICs der Verstärkerschaltung einfach realisiert werden, wie sich aus den weiteren Ausführungen ergibt.

In vorteilhafter Ausgestaltung der Erfindung ist das zuschaltbare Kerbfilter integral mit einem Koppelkondensator der Verbindungsbeschaltung ausgeführt. Dies ermöglicht eine Vereinfachung des Aufbaus des Ultraschallsensors und insbesondere der Verbindungsbeschaltung, da weniger zusätzliche Elemente erforderlich sind, um das Kerbfilter zu realisieren. Außerdem kann die Verbindungsbeschaltung insgesamt kompakt ausgeführt werden, was insbesondere bei einem geringen Platzangebot vorteilhaft ist. Auch kann das Kerbfilter auf diese Weise einfach in die Verbindungsbeschaltung integriert werden, so dass im nicht zugeschalteten Zustand eine ungewollte Beeinflussung der elektrischen Signale in der Verbindungsbeschaltung vermieden werden kann. Der Koppelkondensator kann im Normalbetrieb, d.h. im nicht zugeschalteten Zustand des Kerbfilters, seine übliche Koppelfunktion und/oder Strombegrenzung durchführen.

In vorteilhafter Ausgestaltung der Erfindung ist das Kerbfilter als frequenzeinstellbares Kerbfilter mit einstellbarer Filterfrequenz ausgeführt, und der Ultraschallsensor ist ausgeführt, die Filterfrequenz des Kerbfilters in Übereinstimmung mit einer Störfrequenz der Störung beim Empfang der Ultraschallechos einzustellen. Das Kerbfilter kann beispielsweise zwischen zwei oder mehreren disktreten Filterfrequenzen umgeschaltet werden. Die disktreten Filterfrequenzen können z.B. für verschiedene Störfrequenzen potentieller, bekannter Störer vorgegeben sein. Eine solche Umschaltung kann einfach realisiert werden, indem beispielsweise Widerstände oder Kondensatoren in das Kerbfilters zugeschaltet oder getrennt werden, beispielsweise parallel und/oder in Reihe zu bereits vorhandenen Widerständen oder Kondensatoren. Alternativ kann das Kerbfilter beispielsweise in einem vorgegebenen Frequenzbereich verstellbar sein, so dass die Filterfrequenz in diesem vorgegebenen Frequenzbereich eingestellt werden kann. Die Einstellung kann stufenlos oder in Stufen erfolgen, beispielsweise über Potentiometer oder andere einstellbare Komponenten. Insbesondere kann die Verstärkerschaltung ausgeführt sein, die Einstellung der Filterfrequenz des Kerbfilters durchzuführen. Besonders bevorzugt ist die Verstärkerschaltung mit einer anwendungsspezifischen integrierten Schaltung mit wenigstens einem GPIO ausgeführt, um die Filterfrequenz des Kerbfilters einzustellen.

In vorteilhafter Ausgestaltung der Erfindung ist der Ultraschallsensor ausgeführt, ein Zuschaltsignal zu empfangen, insbesondere von einem Steuergerät eines Fahrunterstützungssystems, wobei das empfangene Zuschaltsignal die Störung beim Empfang der Ultraschallechos anzeigt, und der Ultraschallsensor ist weiter ausgeführt, das Kerbfilter abhängig von dem Empfang des Zuschaltsignals zuzuschalten. Das Kerbfilter wird also in dem Ultraschallsensor abhängig von dem empfangenen Zuschaltsignal zugeschaltet werden. Das Zuschaltsignal kann ein analoger Signalpegel oder auch eine Informationseinheit sein, die über eine Datenverbindung als digitales Signal übertragen wird, beispielsweise von einem angeschlossenen Steuergerät. Das Zuschalten des Kerbfilters erfolgt in diesem Fall ohne eine entsprechende Signalverarbeitung durch den jeweiligen Ultraschallsensor, um die Störung beim Empfang der Ultraschallechos zu ermitteln.

In vorteilhafter Ausgestaltung der Erfindung weist der Ultraschallsensor eine Störungserkennungseinheit auf, die ausgeführt ist, die Störung beim Empfang der Ultraschallechos zu ermitteln, und der Ultraschallsensor ist ausgeführt, das Kerbfilter abhängig von der ermittelten Störung beim Empfang der Ultraschallechos zuzuschalten. Das Zuschalten des Kerbfilters erfolgt somit basierend auf einer Signalverarbeitung durch den jeweiligen Ultraschallsensor, um die Störung zu ermitteln. Bei einem frequenzeinstellbaren Kerbfilter kann die Störungserkennungseinheit zusätzlich ausgeführt sein, die Störfrequenz der Störung beim Empfang der Ultraschallechos zu ermitteln, so dass die Filterfrequenz des Kerbfilters entsprechend eingestellt werden kann. Alternativ kann die Filterfrequenz des Kerbfilters basierend auf einem externen Signal, das von dem Ultraschallsensor empfangen wird, eingestellt werden.

In vorteilhafter Ausgestaltung der Erfindung ist das Kerbfilter konfigurierbar, und der Ultraschallsensor ist ausgeführt, das Kerbfilter abhängig von einer Art der Störung im Bereich der Filterfrequenz beim Empfang der Ultraschallechos zu konfigurieren. In Analogie mit dem Zuschalten des Kerbfilters kann der Ultraschallsensor ausgeführt sein, ein Konfigurationssignal zu empfangen, insbesondere von einem Steuergerät eines Fahrunterstützungssystems, wobei das empfangene Konfigurationssignal die Art der Störung beim Empfang der Ultraschallechos anzeigt, und der Ultraschallsensor weiter ausgeführt ist, das Kerbfilter abhängig von dem Empfang des Konfigurationssignals zu konfigurieren. Alternativ kann der Ultraschallsensor eine Störungserkennungseinheit aufweisen, die ausgeführt ist, die Art der Störung beim Empfang der Ultraschallechos zu ermitteln. Darauf basierend kann der Ultraschallsensor das Kerbfilter konfigurieren. Durch die Konfiguration kann das Filter angepasst werden, um einen ungewünschten Informationsverlust durch das Filter möglichst zu vermeiden oder zumindest auf ein notwendiges Maß zu reduzieren. Die Art der Störung kann beispielsweise durch eine Störfrequenz, eine Bandbreite der Störung und/oder einen Pegel der Störung angegeben werden.

In vorteilhafter Ausgestaltung der Erfindung ist der als Master ausgeführte Ultraschallsensor ausgeführt, eine Störung im Bereich der Filterfrequenz beim Empfang der Ultraschallechos zu ermitteln und abhängig von der ermittelten Störung ein Zuschaltsignal, das die Störung im Bereich der Filterfrequenz beim Empfang der Ultraschallechos anzeigt, an den wenigstens einen als Slave ausgeführten Ultraschallsensor zu übertragen, und/oder der als Master ausgeführte Ultraschallsensor ist ausgeführt, eine Art der Störung im Bereich der Filterfrequenz beim Empfang der Ultraschallechos zu ermitteln und abhängig von der ermittelten Art der Störung ein Konfigurationssignal zur Konfiguration des Kerbfilters an den wenigstens einen als Slave ausgeführten Ultraschallsensor zu übertragen. Es kann also von dem als Master ausgeführten Ultraschallsensor ermittelt werden, ob eine Störung beim Empfang der Ultraschallechos vorliegt, und/oder welche Art Störung beim Empfang der Ultraschallechos vorliegt. Dies kann umfassen, dass der als Master ausgeführte Ultraschallsensor beispielsweise eine Störfrequenz der Störung beim Empfang der Ultraschallechos ermittelt. Zusätzlich kann eine Stärke der Störung, beispielsweise ein Pegel oder eine Frequenzbreite der Störung, ermittelt werden. Die Störung und/oder die Art der Störung kann für einzelne Ultraschallsensoren individuell oder für Gruppen von Ultraschallsensoren gemeinsam ermittelt werden. Entsprechend kann das Zuschaltsignal zusätzliche Informationen beinhalten in Bezug auf die ermittelte Störfrequenz. Alternativ oder zusätzlich kann das Konfigurationssignal zusätzliche Informationen beinhalten in Bezug auf die Art der Störung, beispielsweise die ermittelte Störfrequenz, den Pegel oder die Frequenzbreite der Störung. Der als Master ausgeführte Ultraschallsensor kann das Zuschaltsignal und/oder das Konfigurationssignal an einzelne Ultraschallsensoren oder an Gruppen von Ultraschallsensoren, der oder die als Slave(s) konfiguriert ist/sind, senden, so dass die Ultraschallsensoren ihre Kerbfilter individuell oder in Gruppen zuschalten und/oder konfigurieren können. Prinzipiell kann der als Master ausgeführte Ultraschallsensor auch Informationen über eine Störung und/oder eine Art der Störung beim Empfang der Ultraschallechos von einer übergeordneten Steuerung erhalten und daraus das Vorliegen der Störung und/oder die Art der Störung ermitteln. Der als Master ausgeführte Ultraschallsensor kann dann wie zuvor beschrieben das Zuschaltsignal und/oder das Konfigurationssignal an die mit ihm verbundenen, als Slave ausgeführten Ultraschallsensoren senden. Die als Slave ausgeführten Ultraschallsensoren schalten dann abhängig von dem Zuschaltsignal ihr Kerbfilter zu und ggf. die Filterfrequenz ein, und/oder führen eine Konfiguration ihrer Kerbfilter durch. Die Ausführungen in Bezug auf das Ermitteln der Störung und/oder der Art der Störung gelten in gleicher Weise für den Master selbst wie auch für damit verbundene Ultraschallsensoren als Slaves.

In vorteilhafter Ausgestaltung der Erfindung ist das das Steuergerät ausgeführt, eine Störung im Bereich der Filterfrequenz beim Empfang der Ultraschallechos zu ermitteln und abhängig von der ermittelten Störung ein Zuschaltsignal, das die Störung im Bereich der Filterfrequenz beim Empfang der Ultraschallechos anzeigt, an den wenigstens einen Ultraschallsensor zu übertragen, und/oder das Steuergerät ist ausgeführt ist, eine Art der Störung im Bereich der Filterfrequenz beim Empfang der Ultraschallechos zu ermitteln und abhängig von der ermittelten Art der Störung ein Konfigurationssignal zur Konfiguration des Kerbfilters an den wenigstens einen Ultraschallsensor zu übertragen. Es kann also von dem Steuergerät ermittelt werden, ob eine Störung beim Empfang der Ultraschallechos vorliegt, und/oder welche Art Störung beim Empfang der Ultraschallechos vorliegt. Dies kann umfassen, dass das Steuergerät eine Störfrequenz der Störung beim Empfang der Ultraschallechos ermittelt. Zusätzlich kann eine Stärke der Störung, beispielsweise ein Pegel oder eine Frequenzbreite der Störung, ermittelt werden. Die Störung und/oder die Art der Störung kann für einzelne Ultraschallsensoren individuell oder für Gruppen von Ultraschallsensoren gemeinsam ermittelt werden. Entsprechend kann das Zuschaltsignal zusätzliche Informationen beinhalten in Bezug auf die ermittelte Störfrequenz. Alternativ oder zusätzlich kann das Konfigurationssignal zusätzliche Informationen beinhalten in Bezug auf die Art der Störung, beispielsweise die ermittelte Störfrequenz, den Pegel oder die Frequenzbreite der Störung. Das Steuergerät kann das Zuschaltsignal und/oder das Konfigurationssignal an einzelne Ultraschallsensoren oder an Gruppen von Ultraschallsensoren senden, so dass die Ultraschallsensoren ihre Kerbfilter individuell oder in Gruppen zuschalten und/oder konfigurieren können. Prinzipiell kann das Steuergerät auch Informationen über eine Störung und/oder eine Art der Störung beim Empfang der Ultraschallechos von einer übergeordneten Steuerung erhalten und daraus das Vorliegen der Störung und/oder die Art der Störung ermitteln. Das Steuergerät kann dann wie zuvor beschrieben das Zuschaltsignal und/oder das Konfigurationssignal an die mit ihm verbundenen Ultraschallsensoren senden. Die Ultraschallsensoren schalten dann abhängig von dem Zuschaltsignal bzw. dem Konfigurationssignal ihr Kerbfilter zu, die Filterfrequenz ein, und/oder führen eine Konfiguration ihrer Kerbfilter durch.

Nachfolgend wird die Erfindung unter Bezugnahme auf die anliegende Zeichnung anhand bevorzugter Ausführungsformen näher erläutert. Die dargestellten Merkmale können sowohl jeweils einzeln als auch in Kombination einen Aspekt der Erfindung darstellen. Merkmale verschiedener Ausführungsbeispiele sind übertragbar von einem Ausführungsbeispiel auf ein anderes.

Es zeigt
- Fig. 1: eine schematische Ansicht eines Fahrzeugs mit einem Umgebungserfassungssystem, das Ultraschallsensoren und ein Steuergerät umfasst, die über eine Datenverbindung verbunden sind, gemäß einer ersten, bevorzugten Ausführungsform,
- Fig. 2: eine schematische Darstellung funktionaler Komponenten eines Ultraschallsensors aus Figur 1 mit einem an eine Ultraschallmembran angekoppelten Piezoelement, einer Verbindungsbeschaltung und einer Verstärkerschaltung in einem Normalbetrieb,
- Fig. 3: eine schematische Darstellung der funktionalen Komponenten des Ultraschallsensors aus Figur 1 mit einem Kerbfilter als Doppel-T-Filter gemäß der ersten Ausführungsform,
- Fig. 4: eine detaillierte Darstellung des Kerbfilters aus Fig. 3 mit einem Aufbau basierend auf einem Widerstandsnetzwerk und einem Kondensatornetzwerk,
- Fig. 5: eine schematische Darstellung eines Umgebungserfassungssystems gemäß einer zweiten Ausführungsform mit einer Mehrzahl Ultraschallsensoren und einem Steuergerät, die kaskadierend über eine Datenverbindung verbunden sind,
- Fig. 6: eine schematische Darstellung eines Ultraschallerfassungssystems gemäß einer dritten Ausführungsform mit einer Mehrzahl Ultraschallsensoren, die kaskadierend über eine Datenverbindung miteinander verbunden sind,
- Fig. 7: einen Verlauf der Dämpfung des Kerbfilters aus Fig. 3 in einer Konfiguration als Doppel-T-Filter mit einer maximalen Dämpfung von über 50 dB bei einer Filterfrequenz von ~150 kHz und einer Dämpfung von etwa 5 dB im Bereich einer Ultraschallfrequenz von etwa 50 kHz, und
- Fig. 8: einen Verlauf der Dämpfung des Kerbfilters aus Fig. 3 in einer Konfiguration als (Einfach-) T-Filter mit einer maximalen Dämpfung von etwa 10 dB bei einer Filterfrequenz von ~150 kHz und einer Dämpfung von etwa 3 dB im Bereich einer Ultraschallfrequenz von etwa 50 kHz.

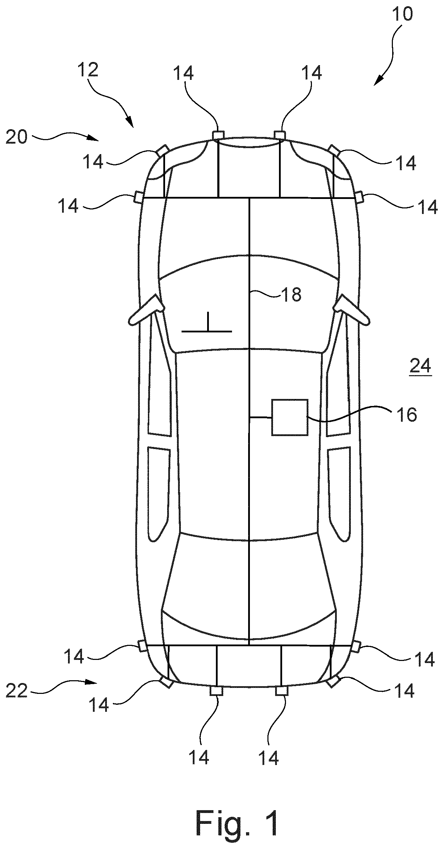

Die Figur 1 zeigt ein Fahrzeug 10 mit einem Fahrunterstützungssystem 12 gemäß einer ersten, bevorzugten Ausführungsform. Das Fahrunterstützungssystem 12 ist in diesem Ausführungsbeispiel allgemein als Umgebungserfassungssystem ausgeführt und kann Teil eines weitergehenden Unterstützungssystems sein.

Das Fahrunterstützungssystem 12 umfasst eine Mehrzahl Ultraschallsensoren 14 und ein Steuergerät 16, wobei die Ultraschallsensoren 14 und das Steuergerät 16 über eine Datenverbindung 18 miteinander verbunden sind. Das Steuergerät 16 ist eine Datenverarbeitungseinheit mit einem Prozessor und einem Speicher, um ein darin gespeichertes Programm auszuführen. Solche Steuergeräte 16 sind im Automobilbereich auch als "electronic control unit" (ECU) bekannt. Die Datenverbindung 18 ist hier als Datenbus ausgeführt, an den alle Ultraschallsensoren 14 und das Steuergerät 16 gemeinsam angeschlossen sind. Dabei können für die Datenverbindung 18 unterschiedliche Topologien und für die Datenübertragung darüber unterschiedliche Protokolle verwendet werden, die als solche im Stand der Technik bekannt sind. In diesem Ausführungsbeispiel ist die Datenverbindung 18 beispielsweise nach einem der Standards CAN, FlexRay, oder LIN ausgeführt.

Die Ultraschallsensoren 14 sind in zwei Gruppen zu jeweils sechs Ultraschallsensoren 14 entlang einer Vorderseite 20 und einer Rückseite 22 des Fahrzeugs 10 angeordnet. Die Ultraschallsensoren 14 sind zum Überwachen einer Umgebung 24 des Fahrzeugs 10 ausgeführt und entsprechend an dem Fahrzeug 10 angeordnet. Die Ultraschallsensoren 14 senden ihre Sensorinformationen über die Datenverbindung 18 an das Steuergerät 16, welches die Sensorinformationen empfängt und verarbeitet, um eine Umgebung 24 des Fahrzeugs 10 zu erfassen. Entsprechend ist das Fahrunterstützungssystem 12 in diesem Ausführungsbeispiel zur Erfassung der Umgebung 24 des Fahrzeugs 10 ausgeführt.

Die Erfassung der Umgebung 24 des Fahrzeugs 10 mit dem Fahrunterstützungssystem 12 erfolgt, indem einer oder mehrere der Ultraschallsensoren 14 Ultraschallpulse aussendet oder aussenden. Ultraschallechos dieser Ultraschallpulse werden mit jeweils einem oder mehreren der Ultraschallsensoren 14 empfangen. Das Aussenden von Ultraschallpulsen kann also für jeden Ultraschallsensor 14 unabhängig vom Empfangen der Ultraschallechos sein. Alternativ können die Ultraschallsensoren 14 jeweils Ultraschallechos der von ihnen selbst ausgesendeten Ultraschallpulse empfangen.

Das Steuergerät 16 empfängt die Sensorinformation von den Ultraschallsensoren 14. Das Steuergerät 16 kann dabei beispielsweise Hüllkurven von den Ultraschallsensoren 14 empfangen, oder lediglich Informationen über relevante, empfangene Ultraschallechos. Diese Sensorinformationen werden von dem Steuergerät 16 verarbeitet, um so die Erfassung der Umgebung 24 des Fahrzeugs 10 durchzuführen.

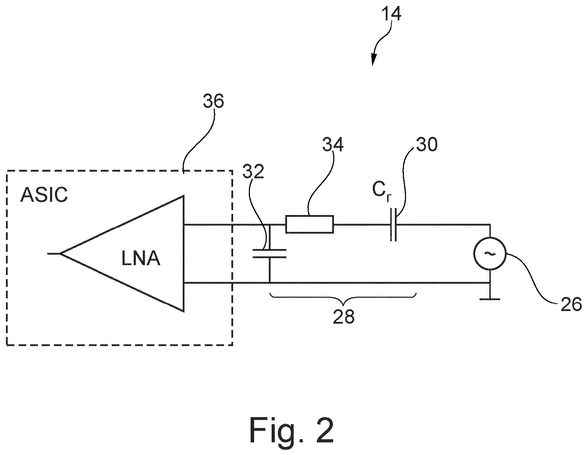

Jeder der Ultraschallsensoren 14 umfasst eine Ultraschallmembran zum Aussenden der Ultraschallpulse und zum Empfangen der Ultraschallechos, an die ein Piezoelement 26 angekoppelt ist, welches in Figur 2 schematisch dargestellt ist. Das Piezoelement 26 ist innenseitig an die Ultraschallmembran geklebt und führt eine elektromechanische Energiewandlung durch. Entsprechendes gilt beim Aussenden von Ultraschallpulsen mit dem jeweiligen Ultraschallsensor 14.

Weiter umfasst jeder der Ultraschallsensoren 14 eine Verbindungsbeschaltung 28 mit einem Koppelkondensator 30 und einem HF-Tiefpassfilter, das durch einen Kondensator 32 und einen Widerstand 34 gebildet wird. Das HF-Tiefpassfilter filtert hochfrequente Störungen. Zusätzlich wird eine Strombegrenzung für Frequenzen typischerweise weit oberhalb der Arbeitsfrequenz durchgeführt. Dieser Aufbau ist ebenfalls in Figur 2 zu erkennen. Schließlich umfasst jeder der Ultraschallsensoren 14 eine Verstärkerschaltung 36. Die Verbindungsbeschaltung 28 verbindet das Piezoelement 26 und die Verstärkerschaltung 36 elektrisch. Beim Empfangen der Ultraschallechos mit dem Ultraschallsensor 14 werden von dem Piezoelement 26 erzeugte elektrische Signale über die Verbindungsbeschaltung 28 der Verstärkerschaltung 36 zugeführt. Die Verstärkerschaltung 36 verstärkt die elektrischen Signale und stellt ein Empfangssignal bereit, beispielsweise als Hüllkurve. Die Verstärkerschaltung 36 ist in diesem Ausführungsbeispiel mit einer anwendungsspezifischen integrierten Schaltung (ASIC) ausgeführt.

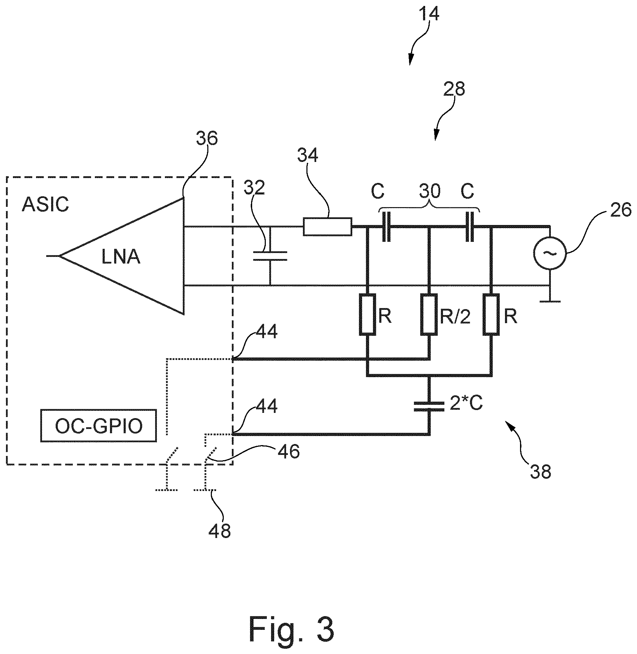

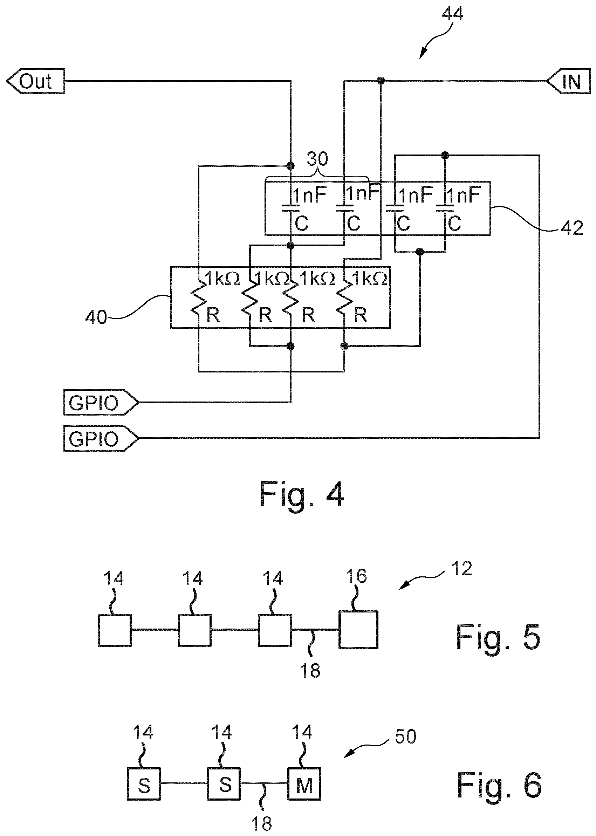

Die Verbindungsbeschaltung 28 umfasst weiterhin ein zuschaltbares Kerbfilter 38 mit einer Filterfrequenz f_{F}, das in Figur 3 als Teil der Verbindungsbeschaltung 28 und in Figur 4 alleine dargestellt ist. In der Darstellung in Figur 2 ist das Kerbfilter 38 nicht dargestellt, um den Zustand mit nicht zugeschaltetem Kerbfilter 38 darzustellen, in dem des Kerbfilter 38 ohne Funktion ist und die Funktion der Verbindungsbeschaltung 28 nicht beeinflusst.

Das Kerbfilter 38 umfasst ein schmales Sperrband um seine Filterfrequenz f_{F}, so dass der Frequenzgang einer tiefen Kerbe mit hoher Selektivität entspricht. Somit können Störungen, die bei einer bestimmten Störfrequenz auftreten, gefiltert werden. Im vorliegenden Ausführungsbeispiel weist das Kerbfilter 38 eine Filterfrequenz f_{F} von etwa 150 kHz auf, die einer Störfrequenz entspricht, wie sie beispielsweise durch das induktive Laden von Elektrofahrzeugen erzeugt wird.

Das zuschaltbare Kerbfilter 38 ist vorliegend als Doppel-T-Filter ausgeführt, wie am besten in Figur 3 zu erkennen ist. Das Kerbfilter 38 hat einen Aufbau aus gleichartigen Widerständen R und mit gleichartigen Kondensatoren C, die in ihrer Anordnung ein Doppel-T bilden. Entsprechend ist das Kerbfilter 38 aus lediglich zwei verschiedenen, passiven Komponenten aufgebaut. Die gleichartigen Widerstände R sind Teil eines entsprechenden Widerstandsnetzwerks 40 mit insgesamt vier gleichartigen Widerständen R. Die gleichartigen Kondensatoren C sind Teil eines entsprechenden Kondensatornetzwerks 42 mit insgesamt vier gleichartigen Kondensatoren C. Verschiedene Widerstandswerte oder Kapazitäten werden, wie sich aus den Figuren 3 und 4 ergibt, realisiert, indem Widerstände R bzw. Kondensatoren C des entsprechenden Widerstandsnetzwerks 40 bzw. Kondensatornetzwerks 42 in Reihe oder parallel verschaltet werden. So ist beispielsweise der in Figur 3 untere Kondensator durch eine Parallelschaltung von zwei Kondensatoren C des Kondensatornetzwerks 42 gebildet, und der in der Figur 3 mittlere Widerstand ist durch eine Parallelschaltung von zwei Widerständen R des entsprechenden Widerstandsnetzwerks 40 gebildet.

Dabei ist das Kerbfilter 38 integral mit dem Koppelkondensator 30 der Verbindungsbeschaltung 28 ausgeführt, indem zwei der Kondensatoren C des Kondensatornetzwerks 42 in Reihe geschaltet den Koppelkondensator 30 bilden. Diese beiden Kondensatoren C sind integraler Bestandteil eines der 'T' des Kerbfilters 38. Wie sich in Zusammenschau mit Figur 2 ergibt, haben die beiden Kondensatoren C auch bei nicht zugeschaltetem Kerbfilter 38 ihre Funktion als Koppelkondensator 30. Durch die Reihenschaltung der zwei Kondensatoren C weist der Koppelkondensator 30 insgesamt die halbe Kapazität von jedem der beiden Kondensatoren C auf.

Wie in Figur 3 dargestellt, ist das Kerbfilter 38 in die Verbindungsbeschaltung 28 integriert. So ist das Kerbfilter 38 einerseits in seinen Anschlüssen IN und OUT zwischen dem Piezoelement 26 und der Strombegrenzung 34 verbunden, und mit seinen Anschlüssen GPIO mit entsprechenden Ausgängen der Verstärkerschaltung 36.

Wie bereits oben diskutiert wurde, ist die Verstärkerschaltung 36 mit einer anwendungsspezifischen integrierten Schaltung ausgeführt. Die Verstärkerschaltung 36 umfasst in diesem Ausführungsbeispiel zwei universelle Ein-/Ausgänge 44 (GPIOs, engl. general-purpose input/output), die über zwei Schalter 46 der anwendungsspezifischen integrierten Schaltung mit Masse 48 verbindbar sind.

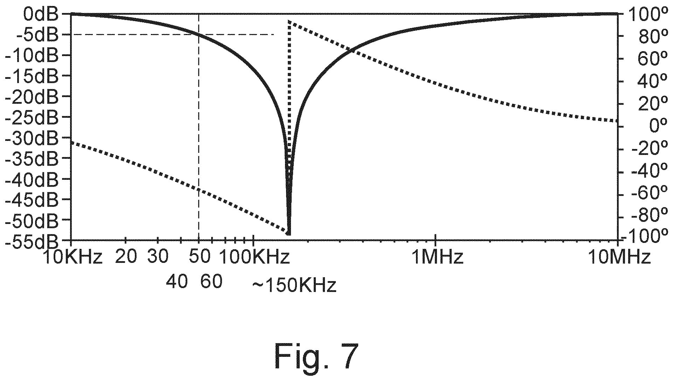

In einem Normalzustand, der in Figur 3 dargestellt ist, sind die Schalter 46 geöffnet, wodurch die Anschlüsse GPIO des Kerbfilters 38 nicht miteinander und auch nicht mit Masse 48 verbunden sind. Das Kerbfilter 38 ist in diesem Zustand nicht aktiv, wobei - wie bereits ausgeführt wurde - zwei der Kondensatoren C des Kondensatornetzwerks 42 den Koppelkondensator 30 bilden. Durch das Schließen der beiden Schalter 46 der anwendungsspezifischen integrierten Schaltung werden die Anschlüsse GPIO des Kerbfilters 38 gegenüber dem Normalzustand mit Masse 48 verbunden. Dadurch wird auch eine elektrische Verbindung zwischen den beiden Anschlüssen GPIO des Kerbfilters 38 hergestellt. Das Kerbfilter 38 ist in diesem Zustand als Doppel-T-Filter aktiv, also zugeschaltet, und führt eine Filterung des von dem Piezoelement 26 bereitgestellten elektrischen Signals gemäß der in Figur 7 dargestellten Filterkennlinie durch. Dadurch ergibt sich für das elektrische Signal im Bereich der Filterfrequenz f_{F} eine Dämpfung von über 50 dB, wohingegen das gewünschte Ultraschallsignal im Bereich von 50 kHz nur eine Dämpfung von etwa 5 dB erfährt.

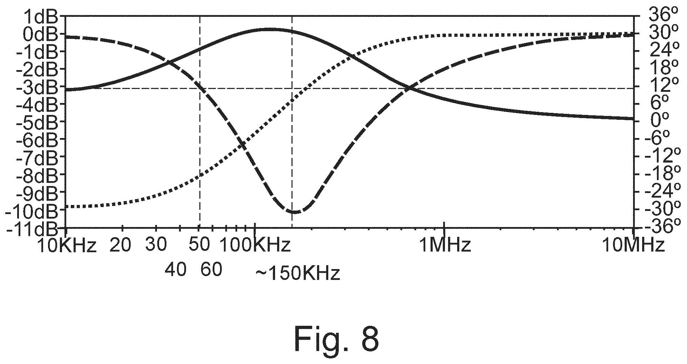

Alternativ kann das Kerbfilter 38 als einfaches T-Filter konfiguriert werden, wenn nur einer der beiden Anschlüsse GPIO des Kerbfilters 38 gegenüber dem Normalzustand mit Masse 48 verbunden ist. Dazu wird einer der beiden Schalter 46 geöffnet, und der andere Schalter 46 wird geschlossen, so dass der entsprechende Anschluss GPIO des Kerbfilters 38 über den geschlossenen Schalter 46 mit Masse 48 verbunden wird, und der andere nicht. Das Kerbfilter 38 führt in diesem Zustand als (einfaches) T-Filter eine Filterung des von dem Piezoelement 26 bereitgestellten elektrischen Signals gemäß der in Figur 8 dargestellten Filterkennlinie durch. Dadurch ergibt sich für das elektrische Signal im Bereich der Filterfrequenz f_{F} eine Dämpfung von etwa 10 dB, wohingegen das gewünschte Ultraschallsignal im Bereich von 50 kHz nur eine Dämpfung von etwa 3 dB erfährt.

Durch die Betätigung der Schalter 46 kann jeder Ultraschallsensor 14 also das Kerbfilter 38 abhängig von einer Art der Störung im Bereich der Filterfrequenz f_{F} beim Empfang der Ultraschallechos abhängig von einem Empfang eines entsprechenden Konfigurationssignals konfigurieren.

Das Steuergerät 16 ist ausgeführt, eine Störung beim Empfang der Ultraschallechos zu ermitteln und abhängig von der ermittelten Störung ein Zuschaltsignal, das die Störung beim Empfang der Ultraschallechos anzeigt, an die Ultraschallsensoren 14 zu übertragen. Das Steuergerät 16 ist weiter ausgeführt, eine Art der Störung im Bereich der Filterfrequenz f_{F} beim Empfang der Ultraschallechos zu ermitteln und abhängig von der ermittelten Art der Störung ein Konfigurationssignal zur Konfiguration des Kerbfilters 38 an die Ultraschallsensoren 14 zu übertragen. Es wird also von dem Steuergerät 16 ermittelt, ob eine Störung beim Empfang der Ultraschallechos vorliegt, und welcher Art diese Störung ist. In diesem Ausführungsbeispiel ermittelt das Steuergerät 16 zusätzlich eine Störfrequenz der Störung beim Empfang der Ultraschallechos und eine Stärke der Störung, die durch einen Pegel und eine Frequenzbreite der Störung bestimmt werden. Die Störung und die Art der Störung können für einzelne Ultraschallsensoren 14 individuell oder für Gruppen von Ultraschallsensoren 14 gemeinsam ermittelt werden. Optional können das Zuschaltsignal und/oder das Konfigurationssignal zusätzliche Informationen beinhalten in Bezug auf die ermittelte Störfrequenz. Das Steuergerät 16 kann das Zuschaltsignal und/oder das Konfigurationssignal an einzelne Ultraschallsensoren 14 oder an Gruppen von Ultraschallsensoren 14 senden, so dass die Ultraschallsensoren 14 ihre Kerbfilter 38 individuell oder in Gruppen zuschalten und/oder konfigurieren können.

Die Ultraschallsensoren 14 sind ausgeführt, das Zuschaltsignal und das Konfigurationssignal von dem Steuergerät 16 zu empfangen und das Kerbfilter 38 abhängig von dem Empfang des Zuschaltsignals zuzuschalten und zu konfigurieren. Das Kerbfilter 38 wird also in den jeweiligen Ultraschallsensoren 14 abhängig von dem empfangenen Zuschaltsignal zugeschaltet und auch wieder deaktiviert. Im zugeschalteten Zustand wird das Kerbfilter 38 dabei abhängig von dem Konfigurationssignal konfiguriert, wie oben beschrieben wurde.

Das Zuschaltsignal und das Konfigurationssignal sind Informationseinheiten, die über die Datenverbindung 18 als digitale Signale übertragen werden. Das Zuschaltsignal und das Konfigurationssignal können jeweils in separaten Nachrichten oder in einer gemeinsamen Nachricht übertragen werden.

In einer alternativen Ausführungsform weist jeder Ultraschallsensor 14 eine Störungserkennungseinheit auf, die ausgeführt ist, die Störung und außerdem die Art der Störung beim Empfang der Ultraschallechos zu ermitteln. Jeder der Ultraschallsensoren 14 ist in dieser alternativen Ausführungsform ausgeführt, das Kerbfilter 38 abhängig von der ermittelten Störung beim Empfang der Ultraschallechos selbsttätig zuzuschalten und zu konfigurieren. Das Zuschalten und Konfigurieren des Kerbfilters 38 erfolgt somit basierend auf einer Signalverarbeitung durch den jeweiligen Ultraschallsensor 14, um die Störung zu ermitteln. Bei einem frequenzeinstellbaren Kerbfilter 38 kann die Störungserkennungseinheit zusätzlich ausgeführt sein, eine Störfrequenz der Störung beim Empfang der Ultraschallechos zu ermitteln, und die Filterfrequenz f_{F} des Kerbfilters 38 entsprechend einzustellen.

Figur 5 zeigt ein Fahrunterstützungssystem 12 gemäß einer zweiten Ausführungsform. Das Fahrunterstützungssystem 12 der zweiten Ausführungsform kann das Fahrunterstützungssystem 12 der ersten Ausführungsform ersetzen, wobei ggf. mehrere Fahrunterstützungssysteme 12 der zweiten Ausführungsform ein Fahrunterstützungssystem 12 der ersten Ausführungsform ersetzen. Die Fahrunterstützungssysteme 12 der ersten und zweiten Ausführungsform unterscheiden sich lediglich in ihrer Verbindung miteinander, wie nachstehend ausgeführt ist.

Das Fahrunterstützungssystem 12 der zweiten Ausführungsform umfasst eine Mehrzahl Ultraschallsensoren 14 und ein Steuergerät 16, wobei die Ultraschallsensoren 14 und das Steuergerät 16 über eine Datenverbindung 18 miteinander verbunden sind. Die Datenverbindung 18 ist hier als kaskadierender Datenbus ausgeführt, an den alle Ultraschallsensoren 14 und das Steuergerät 16 hintereinander angeschlossen sind. Entsprechend werden Daten jeweils von einem Ultraschallsensor 14 bzw. dem Steuergerät 16 an einen benachbarten Ultraschallsensor 14 bzw. das benachbarte Steuergerät 16 weitergeleitet, bis diese ihren Empfänger erreicht haben.

In dem zweiten Ausführungsbeispiel bildet jede Gruppe von Ultraschallsensoren 14, die entlang der Vorderseite 20 bzw. der Rückseite 22 des Fahrzeugs 10 angeordnet sind, zusammen mit jeweils einem Steuergerät 16 ein unabhängiges Fahrunterstützungssystem 12. Entsprechend ist ein Fahrunterstützungssystem 12 zur Erfassung der Umgebung 24 vor dem Fahrzeug 10 ausgeführt, und ein Fahrunterstützungssystem 12 ist zur Erfassung der Umgebung 24 hinter dem Fahrzeug 10 ausgeführt.

Figur 6 zeigt ein Ultraschallerfassungssystem 50 gemäß einer dritten Ausführungsform. Das Ultraschallerfassungssystem 50 der dritten Ausführungsform kann die Fahrunterstützungssysteme 12 der ersten oder zweiten Ausführungsform ersetzen, wobei ggf. mehrere Ultraschallerfassungssysteme 50 der dritten Ausführungsform ein Fahrunterstützungssystem 12 der ersten Ausführungsform ersetzen. Das Ultraschallerfassungssystem 50 unterscheidet sich von den Fahrunterstützungssystemen 12 dadurch, dass es kein Steuergerät 16 umfasst.

Das Ultraschallerfassungssystem 50 umfasst eine Mehrzahl Ultraschallsensoren 14, die über eine Datenverbindung 18 miteinander verbunden sind. Die Datenverbindung 18 ist hier als kaskadierender Datenbus ausgeführt, an den alle Ultraschallsensoren 14 hintereinander angeschlossen sind. Entsprechend werden Daten jeweils von einem Ultraschallsensor 14 an einen benachbarten Ultraschallsensor 14 weitergeleitet, bis diese ihren Empfänger erreicht haben. Wie in Figur 6 gezeigt ist, ist einer der Ultraschallsensoren 14 als Master M ausgeführt, während die anderen Ultraschallsensoren 14 als Slaves S ausgeführt sind. Der als Master M ausgeführte Ultraschallsensor 14 empfängt die Sensorinformation von den als Slaves S ausgeführten Ultraschallsensoren 14 und verarbeitet sie, um die Umgebung 24 des Fahrzeugs 10 zu erfassen.

In dem dritten Ausführungsbeispiel bildet jede Gruppe von Ultraschallsensoren 14, die entlang der Vorderseite 20 bzw. der Rückseite 22 des Fahrzeugs 10 angeordnet sind, ein unabhängiges Ultraschallerfassungssystem 50. Entsprechend ist ein Ultraschallerfassungssystem 50 zur Erfassung der Umgebung 24 vor dem Fahrzeug 10 ausgeführt, und ein Ultraschallerfassungssystem 50 ist zur Erfassung der Umgebung 24 hinter dem Fahrzeug 10 ausgeführt. Die Ultraschallsensoren 14 des Ultraschallerfassungssystem 50 sind gleichartig ausgeführt und unterschieden sich durch ihre Konfiguration als Master M bzw. Slaves S, so dass sie ihre entsprechenden Funktionen durchführen können.

Das Ultraschallerfassungssystem 50 unterscheidet sich von dem Fahrunterstützungssystem 12 der zweiten Ausführungsform durch den Entfall des Steuergeräts 16. Die Aufgaben des Steuergeräts 16 werden bei dem Ultraschallerfassungssystem 50 entsprechend von dem als Master M ausgeführten Ultraschallsensor 14 durchgeführt.

### Bezugszeichenliste

- 10: Fahrzeug
- 12: Fahrunterstützungssystem, Umgebungserfassungssystem
- 14: Ultraschallsensor
- 16: Steuergerät
- 18: Datenverbindung, Datenbus
- 20: Vorderseite
- 22: Rückseite
- 24: Umgebung
- 26: Piezoelement
- 28: Verbindungsbeschaltung
- 30: Koppelkondensator
- 32: HF-Tiefpassfilter
- 34: Strombegrenzung
- 36: Verstärkerschaltung
- 38: Kerbfilter
- 40: Widerstandsnetzwerk
- 42: Kondensatornetzwerk
- 44: universeller Ein-/Ausgang
- 46: Schalter
- 48: Masse
- 50: Ultraschallerfassungssystem

- R: Widerstand
- C: Kondensator
- IN: Anschluss
- OUT: Anschluss
- GPIO: Anschluss
- M: Master
- S: Slave

## Patentansprüche

1. Ultraschallsensor (14) zum Aussenden von Ultraschallsignalen und zum Empfangen von Ultraschallechos, insbesondere zur Verwendung an einem Fahrzeug (10), mit
einer Ultraschallmembran,
einem an der Ultraschallmembran angebrachten Piezoelement (26),
einer Verstärkerschaltung (36), und
einer Verbindungsbeschaltung (28), welche das Piezoelement (26) und die Verstärkerschaltung (36) elektrisch verbindet,
**dadurch gekennzeichnet, dass**
die Verbindungsbeschaltung (28) ein zuschaltbares Kerbfilter (38) mit einer Filterfrequenz (f_{F}) umfasst, und
der Ultraschallsensor (14) ausgeführt ist, das Kerbfilter (38) bei einer Störung im Bereich der Filterfrequenz (f_{F}) beim Empfang der Ultraschallechos zuzuschalten.

2. Ultraschallsensor (14) nach Anspruch 1, **dadurch gekennzeichnet, dass** das zuschaltbare Kerbfilter als Doppel-T-Filter ausgeführt ist.

3. Ultraschallsensor (14) nach einem der Ansprüche 1 oder 2, **dadurch gekennzeichnet, dass**
das zuschaltbare Kerbfilter (38) einen Aufbau mit gleichartigen Widerständen (R) und/oder mit gleichartigen Kondensatoren (C) aufweist, wobei die gleichartigen Widerstände (R) und/oder die gleichartigen Kondensatoren (C) Teil eines entsprechenden Widerstandsnetzwerks (40) und/oder eines entsprechenden Kondensatornetzwerks (42) sind.

4. Ultraschallsensor (14) nach einem der vorhergehenden Ansprüche, **dadurch gekennzeichnet, dass**
die Verstärkerschaltung (36) mit einer anwendungsspezifischen integrierten Schaltung ausgeführt ist, und
der Ultraschallsensor (14) ausgeführt ist, das Kerbfilter (38) bei einer Störung im Bereich der Filterfrequenz (f_{F}) beim Empfang der Ultraschallechos mittels der anwendungsspezifischen integrierten Schaltung zuzuschalten.

5. Ultraschallsensor (10) nach einem der vorhergehenden Ansprüche, **dadurch gekennzeichnet, dass**
das zuschaltbare Kerbfilter (38) integral mit einem Koppelkondensator (30) der Verbindungsbeschaltung (28) ausgeführt ist.

6. Ultraschallsensor (14) nach einem der vorhergehenden Ansprüche, **dadurch gekennzeichnet, dass**
das Kerbfilter (38) als frequenzeinstellbares Kerbfilter (38) mit einstellbarer Filterfrequenz (f_{F}) ausgeführt ist, und
der Ultraschallsensor (14) ausgeführt ist, die Filterfrequenz (f_{F}) des Kerbfilters (38) in Übereinstimmung mit einer Störfrequenz der Störung beim Empfang der Ultraschallechos einzustellen.

7. Ultraschallsensor (14) nach einem der vorhergehenden Ansprüche, **dadurch gekennzeichnet, dass**
der Ultraschallsensor (14) ausgeführt ist, ein Zuschaltsignal zu empfangen, insbesondere von einem Steuergerät (16) eines Fahrunterstützungssystems (12), wobei das empfangene Zuschaltsignal die Störung beim Empfang der Ultraschallechos anzeigt, und der Ultraschallsensor (14) weiter ausgeführt ist, das Kerbfilter (38) abhängig von dem Empfang des Zuschaltsignals zuzuschalten.

8. Ultraschallsensor (14) nach einem der vorhergehenden Ansprüche, **dadurch gekennzeichnet, dass**
der Ultraschallsensor (14) eine Störungserkennungseinheit aufweist, die ausgeführt ist, die Störung beim Empfang der Ultraschallechos zu ermitteln, und
der Ultraschallsensor (14) ausgeführt ist, das Kerbfilter (38) abhängig von der ermittelten Störung beim Empfang der Ultraschallechos zuzuschalten.

9. Ultraschallsensor (14) nach einem der vorhergehenden Ansprüche, **dadurch gekennzeichnet, dass**
das Kerbfilter (38) konfigurierbar ist, und
der Ultraschallsensor (14) ausgeführt ist, das Kerbfilter (38) abhängig von einer Art der Störung im Bereich der Filterfrequenz (f_{F}) beim Empfang der Ultraschallechos zu konfigurieren.

10. Ultraschallerfassungssystem (50) mit einer Mehrzahl Ultraschallsensoren (14) zur Erfassung einer Umgebung (24) eines Fahrzeugs (10), basierend auf von den Ultraschallsensoren (14) bereitgestellten Sensorinformationen, mit
einer Mehrzahl Ultraschallsensoren (14), die über eine Datenverbindung (18) miteinander verbunden sind, wobei einer der Ultraschallsensoren (14) als Master (M) ausgeführt ist, um die Sensorinformation von wenigstens einem weiteren, als Slave (S) ausgeführten Ultraschallsensor (14) zu empfangen und zu verarbeiten, um die Umgebung (24) des Fahrzeugs (10) zu erfassen,
**dadurch gekennzeichnet, dass**
die Ultraschallsensoren (14) nach einem der vorhergehenden Ansprüche 1 bis 9 ausgeführt sind.

11. Ultraschallerfassungssystem (50) nach Anspruch 10, **dadurch gekennzeichnet, dass**
die Ultraschallsensoren (14) nach Anspruch 7 ausgeführt sind und
der als Master (M) ausgeführte Ultraschallsensor (14) ausgeführt ist, eine Störung im Bereich der Filterfrequenz (f_{F}) beim Empfang der Ultraschallechos zu ermitteln und abhängig von der ermittelten Störung ein Zuschaltsignal, das die Störung im Bereich der Filterfrequenz (f_{F}) beim Empfang der Ultraschallechos anzeigt, an den wenigstens einen als Slave (S) ausgeführten Ultraschallsensor (14) zu übertragen, und/oder
die Ultraschallsensoren (14) nach Anspruch 9 ausgeführt sind, und
der als Master (M) ausgeführte Ultraschallsensor (14) ausgeführt ist, eine Art der Störung im Bereich der Filterfrequenz (f_{F}) beim Empfang der Ultraschallechos zu ermitteln und abhängig von der ermittelten Art der Störung ein Konfigurationssignal zur Konfiguration des Kerbfilters (38) an den wenigstens einen als Slave (S) ausgeführten Ultraschallsensor (14) zu übertragen.

12. Fahrunterstützungssystem (12) eines Fahrzeugs mit
wenigstens einem Ultraschallsensor (14) zur Bereitstellung von Sensorinformation, und
einem Steuergerät (16), wobei
der wenigstens eine Ultraschallsensor (14) und das Steuergerät (16) über eine Datenverbindung (18) miteinander verbunden sind, und das Steuergerät (16) ausgeführt ist, die Sensorinformation von dem wenigstens einen Ultraschallsensor (14) zu empfangen und zu verarbeiten, um die Umgebung (24) des Fahrzeugs (10) zu erfassen,
**dadurch gekennzeichnet, dass**
der wenigstens eine Ultraschallsensor (14) nach einem der vorhergehenden Ansprüche 1 bis 9 ausgeführt ist.

13. Fahrunterstützungssystem (12) nach Anspruch 12, **dadurch gekennzeichnet, dass**
der wenigstens eine Ultraschallsensor (14) nach Anspruch 7 ausgeführt ist, und
das Steuergerät (16) ausgeführt ist, eine Störung im Bereich der Filterfrequenz (f_{F}) beim Empfang der Ultraschallechos zu ermitteln und abhängig von der ermittelten Störung ein Zuschaltsignal, das die Störung im Bereich der Filterfrequenz (f_{F}) beim Empfang der Ultraschallechos anzeigt, an den wenigstens einen Ultraschallsensor (14) zu übertragen, und/oder
der wenigstens eine Ultraschallsensor (14} nach Anspruch 9 ausgeführt ist, und
das Steuergerät (16) ausgeführt ist, eine Art der Störung im Bereich der Filterfrequenz (f_{F}) beim Empfang der Ultraschallechos zu ermitteln und abhängig von der ermittelten Art der Störung ein Konfigurationssignal zur Konfiguration des Kerbfilters (38) an den wenigstens einen Ultraschallsensor (14) zu übertragen.

## Claims

1. Ultrasonic sensor (14) for transmitting ultrasonic signals and for receiving ultrasonic echoes, in particular for use on a vehicle (10), comprising an ultrasonic membrane, a piezoelectric element (26) attached to the ultrasonic membrane, an amplifier circuit (36), and a connection circuit (28) which electrically connects the piezoelectric element (26) and the amplifier circuit (36), **characterized in that** the connection circuit (28) comprises a switchable notch filter (38) with a filter frequency (fF), and the ultrasonic sensor (14) is configured to switch in the notch filter (38) in the event of an interference in the region of the filter frequency (fF) during reception of the ultrasonic echoes.

2. Ultrasonic sensor (14) according to claim 1, **characterized in that** the switchable notch filter is implemented as a twin-T filter.

3. Ultrasonic sensor (14) according to one of claims 1 or 2, **characterized in that** the switchable notch filter (38) has a structure with identical resistors (R) and/or with identical capacitors (C), wherein the identical resistors (R) and/or the identical capacitors (C) are part of a corresponding resistor network (40) and/or a corresponding capacitor network (42).

4. Ultrasonic sensor (14) according to one of the preceding claims, **characterized in that** the amplifier circuit (36) is implemented with an application-specific integrated circuit, and the ultrasonic sensor (14) is configured to switch in the notch filter (38) in the event of an interference in the region of the filter frequency (fF) during reception of the ultrasonic echoes by means of the application-specific integrated circuit.

5. Ultrasonic sensor (10) according to one of the preceding claims, **characterized in that** the switchable notch filter (38) is implemented integrally with a coupling capacitor (30) of the connection circuit (28).

6. Ultrasonic sensor (14) according to one of the preceding claims, **characterized in that** the notch filter (38) is implemented as a frequency-adjustable notch filter (38) with an adjustable filter frequency (fF), and the ultrasonic sensor (14) is configured to adjust the filter frequency (fF) of the notch filter (38) in accordance with an interference frequency of the interference during reception of the ultrasonic echoes.

7. Ultrasonic sensor (14) according to one of the preceding claims, **characterized in that** the ultrasonic sensor (14) is configured to receive a switch-in signal, in particular from a control unit (16) of a driver assistance system (12), wherein the received switch-in signal indicates the interference during reception of the ultrasonic echoes, and the ultrasonic sensor (14) is further configured to switch in the notch filter (38) depending on the reception of the switch-in signal.

8. Ultrasonic sensor (14) according to one of the preceding claims, **characterized in that** the ultrasonic sensor (14) has an interference detection unit which is configured to detect the interference during reception of the ultrasonic echoes, and the ultrasonic sensor (14) is configured to switch in the notch filter (38) depending on the detected interference during reception of the ultrasonic echoes.

9. Ultrasonic sensor (14) according to one of the preceding claims, **characterized in that** the notch filter (38) is configurable, and the ultrasonic sensor (14) is configured to configure the notch filter (38) depending on a type of interference in the region of the filter frequency (fF) during reception of the ultrasonic echoes.

10. Ultrasonic detection system (50) comprising a plurality of ultrasonic sensors (14) for detecting an environment (24) of a vehicle (10), based on sensor information provided by the ultrasonic sensors (14), with a plurality of ultrasonic sensors (14) connected to one another via a data connection (18), wherein one of the ultrasonic sensors (14) is implemented as a master (M) to receive and process the sensor information from at least one further ultrasonic sensor (14) implemented as a slave (S), in order to detect the environment (24) of the vehicle (10), **characterized in that** the ultrasonic sensors (14) are implemented according to one of the preceding claims 1 to 9.

11. Ultrasonic detection system (50) according to claim 10, **characterized in that** the ultrasonic sensors (14) are implemented according to claim 7, and the ultrasonic sensor (14) implemented as a master (M) is configured to detect an interference in the region of the filter frequency (fF) during reception of the ultrasonic echoes and, depending on the detected interference, to transmit a switch-in signal indicating the interference in the region of the filter frequency (fF) during reception of the ultrasonic echoes to the at least one ultrasonic sensor (14) implemented as a slave (S), and/or the ultrasonic sensors (14) are implemented according to claim 9, and the ultrasonic sensor (14) implemented as a master (M) is configured to detect a type of interference in the region of the filter frequency (fF) during reception of the ultrasonic echoes and, depending on the detected type of interference, to transmit a configuration signal for configuring the notch filter (38) to the at least one ultrasonic sensor (14) implemented as a slave (S).

12. Driver assistance system (12) of a vehicle comprising at least one ultrasonic sensor (14) for providing sensor information, and a control unit (16), wherein the at least one ultrasonic sensor (14) and the control unit (16) are connected to one another via a data connection (18), and the control unit (16) is configured to receive and process the sensor information from the at least one ultrasonic sensor (14) in order to detect the environment (24) of the vehicle (10), **characterized in that** the at least one ultrasonic sensor (14) is implemented according to one of the preceding claims 1 to 9.

13. Driver assistance system (12) according to claim 12, **characterized in that** the at least one ultrasonic sensor (14) is implemented according to claim 7, and the control unit (16) is configured to detect an interference in the region of the filter frequency (fF) during reception of the ultrasonic echoes and, depending on the detected interference, to transmit a switch-in signal indicating the interference in the region of the filter frequency (fF) during reception of the ultrasonic echoes to the at least one ultrasonic sensor (14), and/or the at least one ultrasonic sensor (14) is implemented according to claim 9, and the control unit (16) is configured to detect a type of interference in the region of the filter frequency (fF) during reception of the ultrasonic echoes and, depending on the detected type of interference, to transmit a configuration signal for configuring the notch filter (38) to the at least one ultrasonic sensor (14).

## Revendications

1. Capteur à ultrasons (14) pour l'émission de signaux ultrasonores et la réception d'échos ultrasonores, notamment pour une utilisation sur un véhicule (10), comprenant une membrane à ultrasons, un élément piézoélectrique (26) fixé à la membrane à ultrasons, un circuit amplificateur (36), et un circuit de connexion (28) reliant électriquement l'élément piézoélectrique (26) et le circuit amplificateur (36), **caractérisé en ce que** le circuit de connexion (28) comprend un filtre coupe-bande (38) commutable avec une fréquence de filtrage (fF), et le capteur à ultrasons (14) est conçu pour connecter le filtre coupe-bande (38) en cas de perturbation dans la plage de la fréquence de filtrage (fF) lors de la réception des échos ultrasonores.

2. Capteur à ultrasons (14) selon la revendication 1, **caractérisé en ce que** le filtre coupe-bande commutable est réalisé sous la forme d'un filtre en double T.

3. Capteur à ultrasons (14) selon l'une des revendications 1 ou 2, **caractérisé en ce que** le filtre coupe-bande commutable (38) présente une structure avec des résistances identiques (R) et/ou des condensateurs identiques (C), les résistances identiques (R) et/ou les condensateurs identiques (C) faisant partie d'un réseau de résistances correspondant (40) et/ou d'un réseau de condensateurs correspondant (42).

4. Capteur à ultrasons (14) selon l'une des revendications précédentes, **caractérisé en ce que** le circuit amplificateur (36) est réalisé avec un circuit intégré spécifique à l'application, et le capteur à ultrasons (14) est conçu pour connecter le filtre coupe-bande (38) en cas de perturbation dans la plage de la fréquence de filtrage (fF) lors de la réception des échos ultrasonores au moyen du circuit intégré spécifique à l'application.

5. Capteur à ultrasons (10) selon l'une des revendications précédentes, **caractérisé en ce que** le filtre coupe-bande commutable (38) est réalisé de manière intégrée avec un condensateur de couplage (30) du circuit de connexion (28).

6. Capteur à ultrasons (14) selon l'une des revendications précédentes, **caractérisé en ce que** le filtre coupe-bande (38) est réalisé sous la forme d'un filtre coupe-bande à fréquence réglable (38) avec une fréquence de filtrage réglable (fF), et le capteur à ultrasons (14) est conçu pour régler la fréquence de filtrage (fF) du filtre coupe-bande (38) en concordance avec une fréquence de perturbation de la perturbation lors de la réception des échos ultrasonores.

7. Capteur à ultrasons (14) selon l'une des revendications précédentes, **caractérisé en ce que** le capteur à ultrasons (14) est conçu pour recevoir un signal de connexion, notamment d'un appareil de commande (16) d'un système d'aide à la conduite (12), le signal de connexion reçu indiquant la perturbation lors de la réception des échos ultrasonores, et le capteur à ultrasons (14) est en outre conçu pour connecter le filtre coupe-bande (38) en fonction de la réception du signal de connexion.

8. Capteur à ultrasons (14) selon l'une des revendications précédentes, **caractérisé en ce que** le capteur à ultrasons (14) comprend une unité de détection de perturbations conçue pour déterminer la perturbation lors de la réception des échos ultrasonores, et le capteur à ultrasons (14) est conçu pour connecter le filtre coupe-bande (38) en fonction de la perturbation déterminée lors de la réception des échos ultrasonores.

9. Capteur à ultrasons (14) selon l'une des revendications précédentes, **caractérisé en ce que** le filtre coupe-bande (38) est configurable, et le capteur à ultrasons (14) est conçu pour configurer le filtre coupe-bande (38) en fonction d'un type de perturbation dans la plage de la fréquence de filtrage (fF) lors de la réception des échos ultrasonores.

10. Système de détection à ultrasons (50) comprenant une pluralité de capteurs à ultrasons (14) pour la détection d'un environnement (24) d'un véhicule (10), sur la base d'informations de capteurs fournies par les capteurs à ultrasons (14), avec une pluralité de capteurs à ultrasons (14) reliés entre eux par une liaison de données (18), l'un des capteurs à ultrasons (14) étant réalisé en tant que maître (M) pour recevoir et traiter les informations de capteur d'au moins un autre capteur à ultrasons (14) réalisé en tant qu'esclave (S), afin de détecter l'environnement (24) du véhicule (10), **caractérisé en ce que** les capteurs à ultrasons (14) sont réalisés selon l'une des revendications précédentes 1 à 9.

11. Système de détection à ultrasons (50) selon la revendication 10, **caractérisé en ce que** les capteurs à ultrasons (14) sont réalisés selon la revendication 7 et le capteur à ultrasons (14) réalisé en tant que maître (M) est conçu pour déterminer une perturbation dans la plage de la fréquence de filtrage (fF) lors de la réception des échos ultrasonores et, en fonction de la perturbation déterminée, transmettre un signal de connexion indiquant la perturbation dans la plage de la fréquence de filtrage (fF) lors de la réception des échos ultrasonores au moins au capteur à ultrasons (14) réalisé en tant qu'esclave (S), et/ou les capteurs à ultrasons (14) sont réalisés selon la revendication 9, et le capteur à ultrasons (14) réalisé en tant que maître (M) est conçu pour déterminer un type de perturbation dans la plage de la fréquence de filtrage (fF) lors de la réception des échos ultrasonores et, en fonction du type de perturbation déterminé, transmettre un signal de configuration pour la configuration du filtre coupe-bande (38) au moins au capteur à ultrasons (14) réalisé en tant qu'esclave (S).

12. Système d'aide à la conduite (12) d'un véhicule comprenant au moins un capteur à ultrasons (14) pour la fourniture d'informations de capteur, et un appareil de commande (16), l'au moins un capteur à ultrasons (14) et l'appareil de commande (16) étant reliés entre eux par une liaison de données (18), et l'appareil de commande (16) étant conçu pour recevoir et traiter les informations de capteur de l'au moins un capteur à ultrasons (14) afin de détecter l'environnement (24) du véhicule (10), **caractérisé en ce que** l'au moins un capteur à ultrasons (14) est réalisé selon l'une des revendications précédentes 1 à 9.

13. Système d'aide à la conduite (12) selon la revendication 12, **caractérisé en ce que** l'au moins un capteur à ultrasons (14) est réalisé selon la revendication 7, et l'appareil de commande (16) est conçu pour déterminer une perturbation dans la plage de la fréquence de filtrage (fF) lors de la réception des échos ultrasonores et, en fonction de la perturbation déterminée, transmettre un signal de connexion indiquant la perturbation dans la plage de la fréquence de filtrage (fF) lors de la réception des échos ultrasonores à l'au moins un capteur à ultrasons (14), et/ou l'au moins un capteur à ultrasons (14) est réalisé selon la revendication 9, et l'appareil de commande (16) est conçu pour déterminer un type de perturbation dans la plage de la fréquence de filtrage (fF) lors de la réception des échos ultrasonores et, en fonction du type de perturbation déterminé, transmettre un signal de configuration pour la configuration du filtre coupe-bande (38) à l'au moins un capteur à ultrasons (14).
